# FASCICULE DE BREVET EUROPEEN

(11) **EP 0 823 088 B1**
(45) Date de publication et mention de la délivrance du brevet: **08.03.2000**
(21) Numéro de dépôt: 96912091.4
(22) Date de dépôt: 10.04.1996
(51) Int. Cl.: G06F 11/26, G01R 31/28, G06F 11/273

(54) **PROCEDE ET EQUIPEMENT DE TEST AUTOMATIQUE EN PARALLELE DE COMPOSANTS ELECTRONIQUES**
VERFAHREN UND VORRICHTUNG ZUR PARALLELEN AUTOMATISCHEN PRÜFUNG VON ELEKTRONISCHEN SCHALTUNGEN
AUTOMATIC PARALLEL ELECTRONIC COMPONENT TESTING METHOD AND EQUIPMENT

(30) Priorité: 19.04.1995 FR 9504777
(43) Date de publication de la demande: 11.02.1998
(73) Titulaire: SCHLUMBERGER Systèmes, 92120 Montrouge (FR)
(72) Inventeur: FOURNEL, Jean-Claude, F-43140 Saint-Victor Malescours (FR); CHAUSSE, Daniel, F-42100 Saint-Etienne (FR); MURGUE, Jean-Louis, F-42660 Saint-Romain-les-Atheux (FR)
(74) Mandataire: Lemoyne, Didier
(86) Numéro de dépôt international: FR9600539
(87) Numéro de publication internationale: WO9633460

(56) Documents cités:
- EP-A- 0 293 260
- US-A- 5 153 883

## Description

La présente invention concerne un équipement de test automatique en parallèle de composants électroniques.

La plupart des composants électroniques numériques commercialisés sont testés par leur fabricant plusieurs fois avant d'être livrés.

Les testeurs de composants ont pour fonction d'une part de générer des signaux numériques, d'état logique 0 ou 1 par exemple, et, d'autre part, de vérifier par comparaison avec une table de test préétablie, la présence de transitions de sortie. Les signaux générés et les signaux comparés sont programmables aussi bien en temps qu'en niveau. D'une manière générale, un testeur de composants doit générer et/ou comparer des signaux simultanément sur toutes les broches fonctionnelles du composant à tester.

La définition des signaux à générer et/ou comparer est le plus souvent extrêmement complexe. Le test d'un microprocesseur peut entraîner des chaînes de plusieurs millions de 0 ou de 1 dans une même séquence. Pour définir ces signaux, on utilise la notion de période qui détermine une bande de temps à l'intérieur de laquelle un signal plus simple est décrit. Ce signal se décompose en une information de temps, appelé aussi marqueur de temps, et en un événement, une transition par exemple.

L'exécution d'un test fonctionnel se traduit ainsi par le déroulement d'une mémoire principale de programmation de test dont chaque ligne correspond à une période et dont le contenu représente l'information des temps et événements définissant le signal à l'intérieur de la période pour chaque broche. Aux informations de temps et d'événements s'ajoute, entre autres, une instruction destinée à gérer le déroulement de la mémoire de programmation de test. Cette instruction est commune pour l'ensemble des broches fonctionnelles du circuit sous-test. L'instruction la plus courante est celle qui consiste à aller lire la ligne suivante (instruction INC).

Cette architecture basée sur le déroulement d'une mémoire est déterministe en ce sens qu'elle suppose qu'il est possible a priori de savoir exactement ce qui va se passer à un instant donné sur les broches du circuit électronique à tester.

Un testeur de composants logiques est constitué de différentes parties :
- un système et une mémoire principale de programmation,
- un circuit de test par broche comprenant un ensemble de génération de stimuli, ou signaux de forçage, qui doivent être appliqués à la broche considérée, et un ensemble de comparaison des signaux de réponse du composant,
- un ou plusieurs ensembles d'interface, têtes de mesure, permettant d'adapter les stimuli aux contraintes du composant que l'on veut vérifier.

Le nombre des générateurs/comparateurs de stimuli peut être de 32 jusqu'à 1024, dans le cas présent on se limite à 256 générateurs/comparateurs. Il peut y avoir par exemple deux têtes de mesure, chacune comportant 256 adaptateurs.

Afin d'optimiser le coût du test et la surface occupée par le testeur, il est possible de réunir des broches identiques des composants de plusieurs têtes en un seul groupe connecté à un même circuit de test, c'est-à-dire à un même ensemble de génération/comparaison de stimuli. Généralement, des multiplexeurs (un par signal et par broche) placés en sortie de la partie génération/comparaison permettent d'aiguiller les signaux sur une tête ou sur l'autre. Ainsi, un composant est testé sur la tête n° 1 pendant qu'un autre composant est manipulé sur la tête n° 2 et inversement. Ceci permet d'augmenter la capacité du testeur en ajoutant une tête. Typiquement, si le temps de test est identique au temps de manipulation, l'adjonction d'une tête double la capacité du testeur.

S'agissant de composants identiques, il a été proposé des testeurs à deux têtes simultanées dans lesquels les mêmes stimuli sont générés en parallèle sur les deux têtes. De même, les signaux de réponse reçus sont comparés à une table simultanément par des circuits différents. Le testeur gère alors deux résultats : celui venant de la tête n° 1 et celui venant de la tête n° 2. Ainsi, en doublant simplement les circuits de génération et les circuits de comparaison à une table, on double réellement la capacité du testeur sachant que la table est la même pour la tête n° 1 que pour la tête n° 2 puisque les signaux générés et les composants à tester sont identiques.

Le test en parallèle permet donc de tester n composants simultanément de façon similaire au test d'un seul composant. Bien entendu, le test simultané peut se faire sur une même tête ou bien sur plusieurs têtes. La présente invention s'adresse à l'une et l'autre de ces deux alternatives.

Pratiquement, le test en parallèle de composants électroniques est réalisé, de manière connue en soi, à l'aide de circuits de test, chacun de ces circuits permettant de tester les broches par groupes de broches identiques desdits composants.

L'ensemble de génération du circuit de test comporte généralement deux circuits de force destinés à fournir des stimuli, ou signaux de forçage, aux broches identiques des composants sous test, lesdits signaux de forçage étant formés à partir de deux générateurs de temps commandés par la mémoire principale de programmation de test.

L'ensemble de comparaison comprend deux circuits de comparaison recevant des signaux de réponse des broches aux signaux de forçage, lesdits signaux de réponse étant comparés à des signaux de référence délivrés par deux autres générateurs de temps à partir d'une table fournie par la mémoire de programmation de test.

Dans la suite de ce mémoire, on appellera signal de test indifféremment un signal de forçage ou un signal de réponse.

On comprend qu'avec des circuits de test par groupe de broches, les broches d'un composant sont mises en complète correspondance avec les mêmes broches de l'autre composant. Cette modalité de test en parallèle, où les broches identiques sont forcées et comparées de manière synchrone, est bien adaptée au cas le plus fréquent de composants dont le fonctionnement est parfaitement connu et identique d'un composant à l'autre.

Par ailleurs, on connaît du brevet américain n° 4,594,544 des moyens de validation simultanée des broches d'un même groupe de broches identiques des composants à tester, de manière à permettre auxdites broches identiques de recevoir en même temps les mêmes données de programmation de test. On évite ainsi l'adressage séquentiel particulier des broches prises individuellement qui entraînait une grande perte de temps pendant laquelle l'équipement de test n'était pas disponible.

Il peut cependant s'avérer nécessaire d'éliminer du test une broche donnée d'un groupe de broches identiques appartenant à un composant électronique particulier sous test, ceci pour des raisons diverses, comme un défaut de continuité électrique par exemple.

C'est dans le but de répondre à ce besoin que la présente invention propose un équipement de test automatique en parallèle de composants électroniques par groupes constitués par des broches identiques de l'ensemble desdits composants électroniques, ledit équipement comprenant :
- une mémoire principale contenant des données de programmation de test de chaque groupe de broches identiques, lesdites données circulant sur des bus de données respectifs,
- des moyens de validation de programmation de test de chaque groupe de broches identiques,
- au moins un circuit de test associé à chaque groupe de broches identiques, destiné à recevoir lesdites données de programmation de test de la mémoire principale et à les appliquer aux broches dudit groupe de broches identiques,
caractérisé en ce que ledit équipement comprend également des moyens de validation de programmation de test de chacune des broches d'un même groupe de broches identiques.

Ainsi, il est possible d'activer globalement un groupe de broches identiques des composants sous test par la mise en oeuvre des moyens de validation/groupe décrits en référence au brevet américain précité, tout en ayant la possibilité de supprimer du test une ou éventuellement plusieurs broches, identifiées comme défectueuses par exemple, par la mise en oeuvre des moyens de validation/broche de l'équipement de test conforme à l'invention.

Selon un mode de réalisation particulier de l'invention, il est prévu que lesdits moyens de validation de programmation de test d'un groupe de broches identiques étant constitués par un circuit de validation/groupe commandé par une instruction de validation/groupe, lesdits moyens de validation de programmation de test de chaque broche dudit groupe sont constitués par un circuit de validation/broche disposé en série avec le circuit de validation/groupe sur le bus de données correspondant, et commandé par une instruction de validation/broche.

Une caractéristique avantageuse de l'invention permettant la mise en oeuvre de ce mode de réalisation consiste en ce que ledit circuit de validation/broche comprend un circuit de transmission des données de programmation de test de la broche correspondante, commandé par un signal de commande représentatif de l'instruction de validation/broche.

Il est même possible de coupler les deux types de validation lorsque, selon l'invention, ledit signal de commande est également représentatif de l'instruction de validation/groupe.

La description qui va suivre en regard des dessins annexés, donnés à titre d'exemples non limitatifs, fera bien comprendre en quoi consiste l'invention et comment elle peut être réalisée.

La figure 1 est un schéma général d'un équipement de test en parallèle de composants électroniques.

La figure 2 est un schéma d'un circuit de validation d'un équipement de test conforme à l'invention.

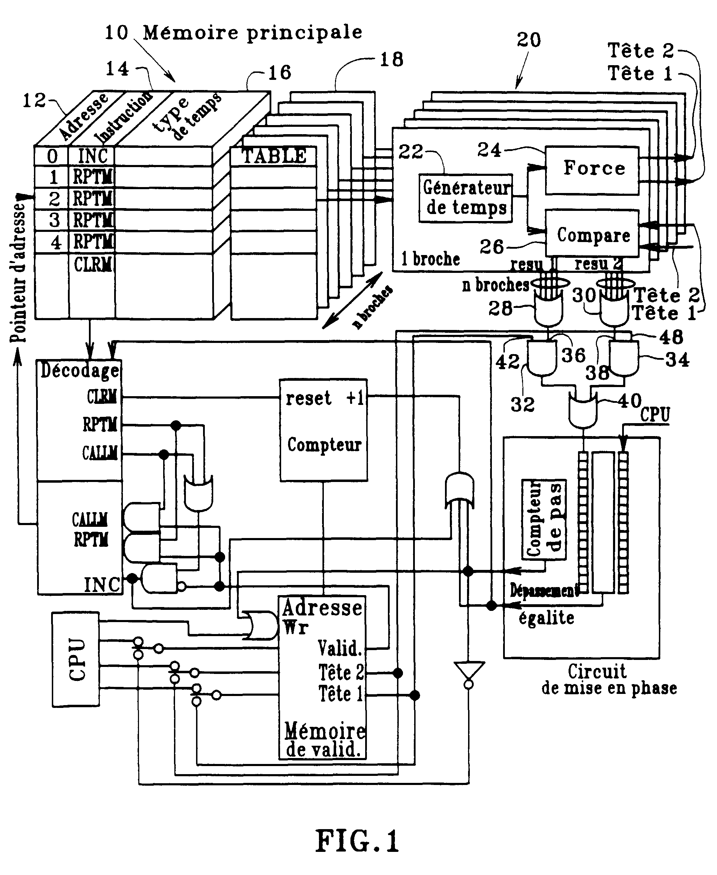

L'équipement de test en parallèle schématisé sur la figure 1 est décrit en détail dans la demande de brevet français n° 94 15559, seuls les éléments indispensables à la compréhension de la présente invention seront repris dans la suite de cet exposé.

La mémoire de programmation de test ou mémoire principale 10 contient les instructions nécessaires au déroulement de la séquence fonctionnelle de test.

Chaque adresse 12 de la mémoire principale 10 définit ;
- une instruction 14 qui est commune à l'ensemble des broches sous test et qui gère le déroulement de la mémoire principale. On nomme CALLM et RPTM des instructions d'appel de la séquence de mise en phase. Lorsque ces instructions sont invoquées, le circuit de mise en phase est activé et gère ainsi le déroulement de la mémoire principale 10 ou des sous-programmes. L'instruction RPTM exécute la même ligne jusqu'à ce que la mise en phase soit trouvée. L'instruction CALLM exécute une série d'instructions jusqu'à ce que la mise en phase soit trouvée. L'instruction CALLM boucle ainsi la mémoire. L'instruction INC consiste simplement à passer à la ligne suivante.
- la définition du type de temps 16 à utiliser pendant l'exécution de cette adresse de la mémoire. Le type de temps est commun pour l'ensemble des broches du testeur et correspond à l'adresse d'une mémoire qui est par broche et dans laquelle est définie la valeur des temps correspondant à cette adresse. Cette architecture de définition des temps correspond à l'architecture dite "séquenceur par broche" qui fait l'objet du brevet US n°5,212,443.
- une table 18 qui correspond au contenu logique (0 ou 1 par exemple) des signaux à envoyer ou à comparer. Cette table est par broche. Le testeur reçoit du composant sous test des signaux de réponse qu'il compare aux données de la table 18.

La mémoire principale 10 de programmation de test permet de définir le signal à générer pour chaque broche. Ainsi, on définit une fonction élémentaire de génération ou de comparaison de signaux, identiques pour chaque broche qui, à partir des informations contenues dans la mémoire 10, génère les stimuli, ou signaux de forçage, et reçoit des signaux de réponse à comparer aux données de la table 18.

Ceci est réalisé à l'aide de circuits 20 de test identiques, chaque circuit étant affecté à une broche et comprenant un ensemble 22 de générateurs de temps contrôlant en parallèle, d'une part, un circuit 24 de force, ou générateur d'événements, envoyant des signaux de forçage aux composants situés, par exemple, sur deux têtes ou composants 1 et 2, et, d'autre part, un circuit 26 de comparaison recevant des signaux de réponse des têtes ou composants 1 et 2 et comparant ces signaux avec les données figurant dans la table 18.

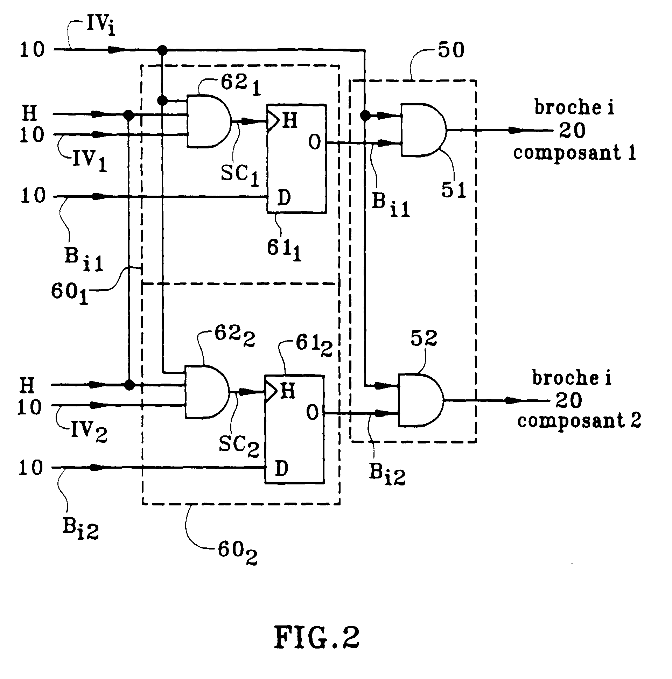

L'ensemble 22 de générateurs de temps définit les instants auxquels il faut générer des fronts de signaux de forçage, les instants où il faut commencer la comparaison des signaux de réponse à la table 18 et les instants où il faut cesser de comparer. Lorsque le circuit 26 de comparaison effectue une comparaison, il génère un résultat, à savoir conforme ou non conforme à la table. Ce résultat est propre à chaque broche et à chaque composant sur lequel sont effectuées des comparaisons. Sur la figure 2, ce résultat est indiqué par "résu 1" pour la tête 1 et par "résu 2" pour la tête 2. En faisant un "ou" logique sur l'ensemble des broches à l'aide des portes OU 28 et 30, respectivement pour la tête 1 et la tête 2, il est possible de savoir si l'ensemble est conforme ou non.

Le schéma de principe donné à la figure 1 d'un équipement de test en parallèle peut être complété, comme l'indique la figure 2, par des moyens de validation de programmation de test pour chaque groupe de broches identiques. On n'a représenté ici qu'un seul groupe de broches, référencées i, identiques à deux composants 1 et 2. Au lieu de deux composants, on pourrait avoir aussi deux têtes de mesure regroupant plusieurs composants.

Ces moyens de validation d' un groupe de broches i sont décrits en détail sous le terme anglo-saxon de "participate register" dans le brevet américain n° 4,594, 544. On peut dire en résumé, d'une part, que lesdits moyens de validation/groupe sont disposés sur les bus Bᵢ₁, Bᵢ₂ de circulation des données de programmation de test en provenance de la mémoire principale 10, et d'autre part, qu'ils sont principalement constitués d'un circuit 50 de validation/groupe, placé entre ladite mémoire principale 10 et le circuit 20 de test, et d'une instruction IVi de validation/groupe.

Sur le schéma de la figure 2, le circuit 50 de validation/groupe comprend essentiellement des portes ET 50₁, 50₂, une par broche du groupe, chacune de ces portes ET recevant sur une première entrée les données de programmation des bus Bi1, Bi2 correspondants, et sur une deuxième entrée l'instruction commune IVi de validation/groupe. On comprend que si l'instruction IVi valide le groupe par un bit 1 les données de programmation de test du groupe seront globalement transmises par toutes les portes ET 51, 52, vers le circuit 20 de test. Par contre, si l'instruction IV1 invalide le groupe dans son ensemble par un bit 0, toutes les broches i seront éliminées du test.

De manière à ne pouvoir n'inhiber qu'une broche par exemple tout en ayant validé le groupe par un bit 1 sur IVi, le circuit de la figure 2 prévoit des moyens de validation de programmation de test de chacune des broches d'un même groupe de broches identiques i.

Comme on peut le voir sur le mode de réalisation de la figure 2, lesdits moyens de validation de chaque broche du groupe sont constitués par un circuit 60₁, 60₂ de validation/broche disposé'en série avec le circuit 50 de validation/groupe sur le bus Bi1, Bi2 de données correspondant, ledit circuit de validation/broche étant par une instruction IV1, IV2 de validation/broche.

Les circuits 60₁, 60₂ de validation/broche de la figure 2 comprennent un circuit 61₁, 61₂ de transmission des données de programmation de test de la broche correspondant, ici une bascule-D commandée par un signal SC1, SC2 de commande représentatif de l'instruction IV1, IV2 de validation/broche, en ce sens que si une broche n'est pas validée à la suite d'une instruction de validation/broche de bit 0 par exemple, le signal de commande prend alors également une valeur de bit 0, bloquant ainsi la bascule-D et la transmission des données de programmation pour cette broche.

Ceci est réalisé lorsque par exemple le signal SC1, SC2 de commande est fourni par une porte ET 62₁, 62₂ à laquelle est appliquée l'instruction IV1, IV2 de validation/broche ainsi qu'un signal d'horloge H nécessaire au fonctionnement de la bascule-D, 61₁, 61₂.

Bien entendu, l'instruction IVi de validation/groupe peut être appliquée à l'entrée de toutes les portes ET 62₁, 62₂, ce qui a pour effet de neutraliser tous les circuits 60₁, 60₂ de validation/groupe si ledit groupe de broches identiques i est invalidé.

Par contre, même si le groupe est validé dans son ensemble, on pourra toujours éliminer une broche donnée en appliquant une instruction de validation/broche, IV1 ou IV2, de bit 0 au circuit 60₁ ou 60₂ de validation/broche correspondant, sans affecter les autres broches.

## Revendications

1. Equipement de test automatique en parallèle de composants électroniques par groupes constitués par des broches identiques (i) de l'ensemble desdits composants électroniques, ledit équipement comprenant :
- une mémoire principale (10) contenant des données de programmation de test de chaque groupe de broches identiques (i), lesdites données circulant sur des bus (Bᵢ₁, Bᵢ₂) de données respectifs.
- des moyens (IVᵢ, 50) de validation de programmation de test de chaque groupe de broches identiques (i),
- au moins un circuit (20) de test associé à chaque groupe de broches identiques (i), destiné à recevoir lesdites données de programmation de test de la mémoire principale (10) et à les appliquer aux broches dudit groupe de broches identiques (i),
caractérisé en ce que ledit équipement comprend également des moyens (IV₁, 60₁ ; IV₂, 60₂) de validation de programmation de test de chacune des broches d'un même groupe de broches identiques (i).

2. Equipement selon la revendication 1, caractérisé en ce que, lesdits moyens de validation de programmation de test d'un groupe de broches identiques étant constitués par un circuit (50) de validation/groupe commandé par une instruction (IVᵢ) de validation/groupe, lesdits moyens de validation de programmation de test de chaque broche dudit groupe sont constitués par un circuit (60₁ ; 60₂) de validation/broche disposé en série avec le circuit (50) de validation/groupe sur le bus (Bᵢ₁ ; Bᵢ₂) de données correspondant, et commandé par une instruction (IV₁, IV₂) de validation/broche.

3. Equipement selon la revendication 2, caractérisé en ce que ledit circuit (60₁ ; 60₂) de validation/broche comprend un circuit (61₁, 61₂) de transmission des données de programmation de test de la broche correspondante, commandé par un signal (SC₁ ; SC₂) de commande représentatif de l'instruction (IV₁, IV₂) de validation/ broche.

4. Equipement selon la revendication 3, caractérisé en ce que ledit signal (SC₁ ; SC₂) de commande est également représentatif de instruction (IVi) de validation/groupe.

5. Equipement selon la revendication 3, caractérisé en ce que ledit circuit de transmission est une bascule-D (61₁ ; 61₂) et en ce que ledit signal (SC₁ ; SC₂) de commande est fourni par une porte ET (62₁, 62₂) à laquelle est appliquée ladite instruction (IV₁; IV₂) de validation/broche.

6. Equipement selon les revendications 4 et 5, caractérisé en ce que l'instruction (IVᵢ) de validation/groupe est également appliquée à l'entrée de ladite porte ET (62₁, 62₂).

## Patentansprüche

1. Vorrichtung zur parallelen automatischen Prüfung von elektronischen Schaltungen in Gruppen, die durch identische Anschlußstifte (i) der Gesamtheit der elektronischen Schaltungen gebildet werden, wobei die Vorrichtung umfaßt:
- einen Hauptspeicher (10), der Testprogrammierdaten jeder Gruppe identischer Anschlußstifte (i) enthält, wobei die Daten auf entsprechenden Datenbussen (Bᵢ₁, Bᵢ₂) umlaufen,
- Mittel (IVᵢ, 50) zum Validieren der Testprogrammierung jeder Gruppe identischer Anschlußstifte (i),
- mindestens einen jeder Gruppe identischer Anschlußstifte (i) zugeordneten Testschaltkreis (20), der zum Empfangen und zum Anlegen der Testprogrammierdaten des Hauptspeichers (10) an die Anschlußstifte der Gruppe identischer Anschlußstifte (i) vorgesehen ist,
dadurch gekennzeichnet, daß die Vorrichtung zudem Mittel (IV₁, 60₁; IV₂, 60₂) zum Validieren der Testprogrammierung jedes Anschlußstiftes derselben Gruppe identischer Anschlußstifte (i) umfaßt.

2. Vorrichtung nach Anspruch 1, dadurch gekennzeichnet, daß die Mittel zum Validieren der Testprogrammierung einer Gruppe identischer Anschlußstifte von einem von einer Instruktion (IVᵢ) zum Validieren/Gruppe gesteuerten Schaltkreis (50) zum Validieren/Gruppe gebildet werden, wobei die Mittel zum Validieren der Testprogrammierung jedes Anschlußstiftes der Gruppe von einem Schaltkreis (60₁; 60₂) zum Validieren/Anschlußstift gebildet werden, der mit dem Schaltkreis (50) zum Validieren/Gruppe seriell auf den Datenbus (Bᵢ₁; Bᵢ₂) geschaltet ist und von einer Instruktion (IV₁, IV₂) zum Validieren/Anschlußstift gesteuert wird.

3. Vorrichtung nach Anspruch 2, dadurch gekennzeichnet, daß der Schaltkreis (60₁; 60₂) zum Validieren/Anschlußstift einen von einem Steuersignal (SC₁; SC₂), das repräsentativ für die Instruktion (IV₁, IV₂) zum Validieren/Anschlußstift ist gesteuerten Übertragungsschaltkreis (61₁, 61₂) für Testprogrammierdaten des entsprechenden Anschlußstiftes umfaßt.

4. Vorrichtung nach Anspruch 3, dadurch gekennzeichnet, daß das Steuersignal (SC₁; SC₂) gleichfalls repräsentativ für die Instruktion (IVᵢ) zum Validieren/Gruppe ist.

5. Vorrichtung nach Anspruch 3, dadurch gekennzeichnet, daß der Übertragungsschaltkreis ein D-Flip-Flop (61₁; 61₂) ist und daß das Steuersignal (SC₁; SC₂) von einem UND-Gatter (61₁; 62₂) geliefert wird, an welches die Instruktion (IV₁; IV₂) zum Validieren/Anschlußstift angelegt wird.

6. Vorrichtung nach Anspruch 4 oder 5, dadurch gekennzeichnet, daß die Instruktion (IVᵢ) zum Validieren/Gruppe ebenfalls an den Eingang des UND-Gatters (62₁, 62₂) angelegt wird.

## Claims

1. Equipment for automatically testing electronic components in parallel in groups constituted of identical pins (i) of all of said electronic components, said equipment including:
· a main memory (10) containing test programming data for each group of identical pins (i), said data being conveyed by respective data buses (Bᵢ₁, Bᵢ₂),
· test programming enabling means (IVᵢ, 50) for each group of identical pins (i), and
· at least one test circuit (20) associated with each group of identical pins (i) adapted to receive said test programming data from the main memory (10) and to apply it to the pins of said group of identical pins (i),
characterized in that said equipment also includes test programming enabling means (IV₁, 60₁; IV₂, 60₂) for each pin of the same group of identical pins (i).

2. Equipment according to claim 1 characterized in that, said test programming enabling means for a group of identical pins comprising a group enabling circuit (50) controlled by a group enabling instruction (IVᵢ), said test programming enabling means for each pin of said group comprise a pin enabling circuit (60₁; 60₂) in series with the group enabling circuit (50) on the corresponding data bus (Bᵢ₁; Bᵢ₂) and controlled by a pin enabling instruction (IV₁, IV₂).

3. Equipment according to claim 2 characterized in that said pin enabling circuit (60₁; 60₂) includes a circuit (61₁, 61₂) for transmitting test programming data for the corresponding pin, controlled by a control signal (SC₁; SC₂) representative of the pin enabling instruction (IV₁, IV₂).

4. Equipment according to claim 3 characterized in that said control signal (SC₁; SC₂) is also representative of the group enabling instruction (IVi).

5. Equipment according to claim 3 characterized in that said transmission circuit is a D-type flip-flop (61₁; 61₂) and in that said control signal (SC₁; SC₂) is supplied by an AND gate (62₁; 62₂) to which said pin enabling instruction (IV₁; IV₂) is applied.

6. Equipment according to claims 4 and 5 characterized in that the group enabling instruction (IVᵢ) is also applied to the input of said AND gate (62₁; 62₂).
